# EUROPÄISCHE PATENTSCHRIFT

(11) **EP 1 857 823 B1**
(45) Veröffentlichungstag und Bekanntmachung des Hinweises auf die Patenterteilung: **15.10.2014**
(21) Anmeldenummer: 07107590.7
(22) Anmeldetag: 07.05.2007
(51) Int. Cl.: G01R 15/20

(54) **Vorrichtung zur Strommessung**
Device for current measurement
Dispositif de mesure de courant

(30) Priorität: 16.05.2006 CH 8102006
(43) Veröffentlichungstag der Anmeldung: 21.11.2007
(73) Patentinhaber: Melexis Technologies NV, 3980 Tessenderlo (BE)
(72) Erfinder: Racz, Robert, 6300, Zug (CH); Manco, Angelo, 8952, Schlieren (CH); Krause, Jens, 32369, Rahden (DE); Burmeister, Michael, 4532, Feldbrunnen/SO (CH)
(74) Vertreter: Falk, Urs

(56) Entgegenhaltungen:
- EP-A1- 0 155 391
- EP-A1- 0 292 636
- DE-A1- 19 741 417

## Beschreibung

Die Erfindung betrifft eine Vorrichtung zur Strommessung.

Stromsensoren, die auf der Messung des von einem Strom erzeugten Magnetfelds basieren, werden immer häufiger und für die verschiedenartigsten Anwendungen eingesetzt. Weit verbreitet ist die als C-shape bekannte Technologie, bei der ein Joch aus ferromagnetischem Material einen Stromleiter mit Ausnahme eines dünnen Luftspalts vollständig umschliesst. Im Luftspalt ist ein Hallelement angeordnet, das das von dem im Stromleiter fliessenden Strom erzeugte und vom Joch verstärkte Magnetfeld misst. Diese Technologie hat mehrere Nachteile. Einerseits sind der Miniaturisierung Grenzen gesetzt. Andererseits ist die Montage der Stromsensoren aufwendig, da der Stromleiter durch das Joch hindurchgeführt werden muss. Aus der EP 233988 A1 ist ein Stromsensor bekannt, der insbesondere bei Elektrizitätszählern eingesetzt worden ist. Dieser Stromsensor eignet sich für die Messung grosser Ströme, ist aber aufwendig in der Herstellung. Aus der DE 19741417 A1 ist ein Stromsensor mit einem U-förmig gebogenen Stromleiter und einem Hallelement bekannt. Das Hallelement befindet sich auf einer Platine, die senkrecht zu einer zweiten Hauptplatine angeordnet und mit dieser verbunden ist. Ein Schirm schirmt den Stromsensor gegen äussere Magnetfelder ab. Auch diese Lösung ist ziemlich kompliziert. Aus der WO 03/038452 A1 ist eine Technologie bekannt, die sich vor allem für die Messung kleinerer Ströme eignet. Die Technologie basiert auf der Halbleitertechnologie. Der Stromleiter ist als Teil eines Leadframes gebildet. Der Magnetfeldsensor wird auf dem Stromleiter befestigt und mit dem Stromleiter in ein Gehäuse vergossen. Solche Stromsensoren sind als IC erhältlich. Ein Nachteil dieser Sensoren ist, dass die Abschirmung gegen äussere magnetische Störfelder aufwendig ist.

Aus der EP 155391 A1 ist eine Anordnung zum Messen eines elektrischen Stroms bekannt, bei der ein Magnetfeldsensor in einem zylindrischen oder teilzyliridrischen Gehäuse angeordnet ist. Der Magnetfeldsensor ist von einem elektrischen Stromleiter in Gestalt einer Ω-förmigen Schelle umschlungen. Die Schelle dient zugleich zur Befestigung des Magnetfeldsensors auf einem Träger. Die Schelle kann aus einem ferromagnetischen Material bestehen oder aus Kupfer und auf ihrer Außenseite mit einem ferromagnetischen Wirkstoff beschichtet sein, um den Magnetfeldsensor gegen Störfelder abzuschirmen.

Aus der EP 292636 A1 ist ein Messwandler zum Messen des in einem elektrischen Leiter fliessenden Stroms bekannt. Der Messwandler besteht aus einem dreischenkligen ferromagnetischen Kern, dessen Mittelschenkel mindestens aus einem Steg besteht und mindestens teilweise von einem elektrischen Leiter U-förmig umgeben ist. Jeder Steg besitzt mindestens drei Luftspalte, wobei mindestens ein Magnetfeldsensor in einem der Luftspalte angeordnet ist.

Der Erfindung liegt die Aufgabe zugrunde, einen Stromsensor für die Messung relativ kleiner Ströme im Bereich von typischerweise 0 bis 10A oder 0 bis 20A zu entwickeln, der wenig Platz beansprucht, kostengünstig herstellbar und einfach einsetzbar ist.

Die genannte Aufgabe wird erfindungsgemäss gelöst durch die Merkmale des Anspruchs 1. Vorteilhafte Ausgestaltungen ergeben sich aus den abhängigen Ansprüchen.

Die Erfindung löst die genannte Aufgabe durch einen modularen Aufbau, bei dem die einzelnen Komponenten optimal aufeinander und auf eine Vielzahl von möglichen Anwendungen abgestimmt sind. Die Vorrichtung zur Strommessung ist auf einfache Weise auf eine Leiterplatte integrierbar, wobei die Leiterplatte einen Teil der Vorrichtung bildet. Die Vorrichtung umfasst weiter einen Stromleiter, ein Gehäuse mit einem im Gehäuse angeordneten Magnetfeldsensor für die Messung des Magnetfelds, das von dem durch den Stromleiter fliessenden Strom erzeugt wird, und einen geschlossenen Schirm aus magnetischem Material für die Abschirmung äusserer magnetischer Störfelder. Das Gehäuse wird auf der Leiterplatte montiert, wobei gleichzeitig die elektrischen Verbindungen zwischen dem Magnetfeldsensor und der Leiterplatte hergestellt werden. Der Stromleiter umfasst mindestens einen U-förmigen Strombügel mit drei im wesentlichen orthogonal zueinander verlaufenden Abschnitten. Der Strombügel wird über das Gehäuse gestülpt und auf der Leiterplatte angelötet. Der zu messende Strom wird über einen in die Leiterplatte integrierten Strompfad zum Strombügel zu- und weggeführt. Die drei Abschnitte des U-förmigen Strombügels definieren eine Ebene E. Es ist möglich, mehrere Strombügel nebeneinander oder übereinander anzuordnen, die über entsprechende Strompfade in der Leiterplatte parallel oder seriell verdrahtet sind. Alternativ wird der zu messende Strom über ein Kabel zugeführt, das um das Gehäuse gewickelt wird. Das Kabel übernimmt dabei die Funktion des/der Strombügel. Bei dieser Lösung ist das Gehäuse mit dem Magnetfeldsensor bevorzugt am Rand der Leiterplatte angeordnet und die Leiterplatte mit vom Rand ausgehenden Schlitzen versehen, damit das Kabel auf einfache Weise um das Gehäuse gewickelt werden kann. Der Magnetfeldsensor umfasst einen Halbleiterchip und ist empfindlich auf ein Magnetfeld, das parallel zur aktiven Oberfläche des Halbleiterchips und senkrecht zur Ebene E verläuft. Zwei einander gegenüberliegende Aussenwände des Gehäuses weisen eine Rille auf, die den ersten und den dritten Abschnitt des Strombügels bzw. das Kabel aufnimmt. Der Schirm wird über das Gehäuse gestülpt und liegt an den Aussenwänden beidseitig der Rille an. Die Tiefe der Rille ist so gross bemessen, dass zwischen dem Strombügel und dem Schirm auf jeden Fall ein Luftspalt besteht, so dass der Strombügel und der Schirm elektrisch voneinander getrennt sind, ohne dass weitere Massnahmen wie zum Beispiel eine zusätzliche Isolationsschicht nötig sind. Diese Vorrichtung zeichnet sich durch einen kompakten Aufbau und eine einfache Montage aus. Die einzelnen Komponenten - Gehäuse mit dem Magnetfeldsensor, Strombügel bzw. Kabel, Schirm - werden nacheinander montiert. Weil der Strombügel bzw. das Kabel in eine Rille eingebettet ist und weil der Schirm im Presssitz am Gehäuse anliegt, ergibt sich eine hohe Langzeitstabilität. Weil die aktive Oberfläche des Halbleiterchips senkrecht zu der vom Strombügel aufgespannten Ebene E verläuft, ergibt sich eine schmale Bauform des Gehäuses, die wiederum einen geringen Abstand zwischen den äusseren Abschnitten des Strombügels ermöglicht. Daraus resultiert eine hohe Empfindlichkeit.

Die Erfindung wird nachfolgend anhand von Ausführungsbeispielen und anhand der Zeichnung näher erläutert.

Es zeigen:
- Fig. 1: ein auf einer Leiterplatte befestigtes Gehäuse mit einem Magnetfeldsensor,
- Fig. 2: die Leiterplatte mit dem Gehäuse und einem über das Gehäuse gestülpten Strombügel,
- Fig. 3: die Leiterplatte mit dem Gehäuse und mehrere, nebeneinander angeordnete Strombügel,
- Fig. 4: die Leiterplatte mit dem Gehäuse und mehrere, übereinander angeordnete Strombügel,
- Fig. 5: die Leiterplatte mit dem Gehäuse und einem einmal um das Gehäuse gewickelten Kabel,
- Fig. 6: die Leiterplatte mit dem Gehäuse und einem mehrmals um das Gehäuse gewickelten Kabel,
- Fig. 7: die fertig montierte Vorrichtung zur Strommessung, und
- Fig. 8: ein weiteres Beispiel der fertig montierten Vorrichtung zur Strommessung.

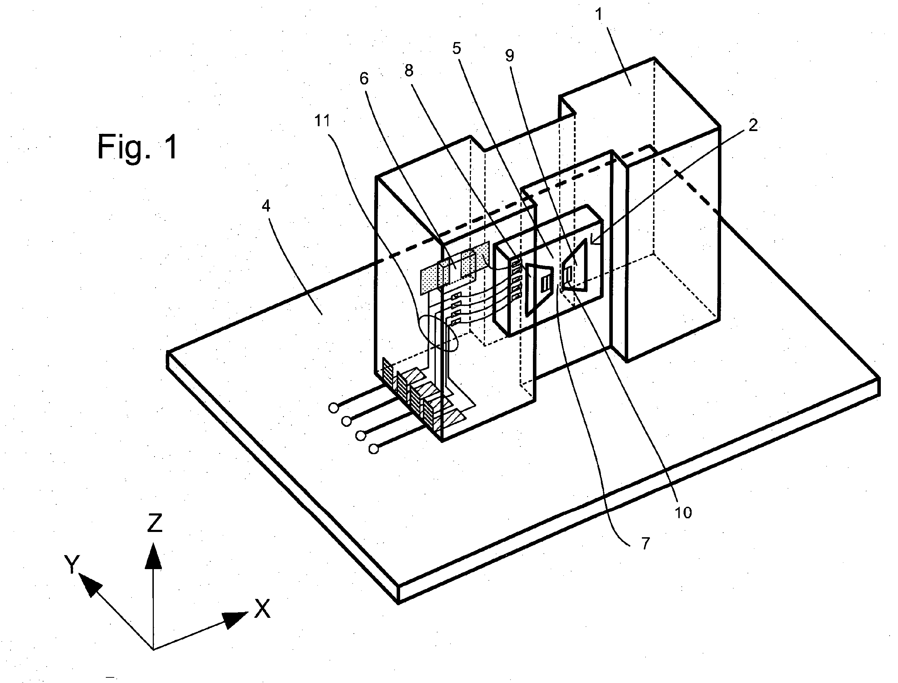

In den Figuren sind die Achsen eines kartesischen Koordinatensystems mit x, y und z bezeichnet. Die Fig. 1 zeigt in perspektivischer und transparenter Darstellung ein Gehäuse 1 mit einem Magnetfeldsensor 2 und einer elektronischen Schaltung für den Betrieb des Magnetfeldsensors 2. Das Gehäuse 1 hat eine relativ flache, im wesentlichen quaderförmige Form. Das Gehäuse 1 ist ausgelegt für eine hochkantige Montage auf einer Leiterplatte 4, d.h. eine schmale Längswand des Gehäuses 1 liegt auf der Leiterplatte 4 auf.

Der Magnetfeldsensor 2 ist empfindlich auf ein in x-Richtung gerichtetes Magnetfeld. Die elektronische Schaltung umfasst einen Halbleiterchip 5 mit integrierten Schaltungen, sowie fakultativ separate elektronische Bauteile 6 wie zum Beispiel Schutzkondensatoren. Es sind verschiedene Typen von Magnetfeldsensoren geeignet. Der in der Fig. 1 dargestellte Magnetfeldsensor 2 umfasst zwei durch einen Luftspalt 7 getrennte Magnetfeldkonzentratoren 8 und 9 und ein Hallelement 10. Die Magnetfeldkonzentratoren 8 und 9 sind auf der aktiven Oberfläche des Halbleiterchips 5 angeordnet. Das Hallelement 10 ist im Halbleiterchip 5 integriert und befindet sich im Bereich des Luftspalts 7 zwischen den Magnetfeldkonzentratoren 8 und 9, wobei vom einen Magnetfeldkonzentrator 8 ausgehende Feldlinien des Magnetfelds das Hallelement 10 durchfluten und auf den anderen Magnetfeldkonzentrator 9 auftreffen. Aus der EP 772046 ist ein Magnetfeldsensor 2 bekannt, bei dem das Hallelement ein sogenanntes horizontales Hallelement ist, das empfindlich ist auf ein Magnetfeld, das senkrecht zur aktiven Oberfläche des Halbleiterchips 5 verläuft. Es sind sogar bevorzugt zwei horizontale Hallelemente vorgesehen, die unterhalb des Randes der Magnetfeldkonzentratoren 8 und 9 angeordnet sind. Das Hallelement 10 kann aber auch ein vertikales Hallelement sein, das empfindlich ist auf ein Magnetfeld, das parallel zur aktiven Oberfläche des Halbleiterchips 5 verläuft. Das vertikale Hallelement ist deshalb vorzugsweise in der Mitte des Luftspalts 7 angeordnet.

Der Magnetfeldsensor 2 soll im wesentlichen nur empfindlich sein auf die x-Komponente eines äusseren Magnetfelds und unempfindlich auf die y- und z-Komponente des äusseren Magnetfelds. Der oben beschriebene Magnetfeldsensor 2 mit den beiden Magnetfeldkonzentratoren 8, 9 und dem Hallelement 10 erfüllt diese Anforderungen in hohem Masse. Der Magnetfeldsensor 2 kann aber auch ein anderer Sensor sein, der diese Anforderung erfüllt, z. B. ein AMR (anisotropic magnetic resistance) oder GMR (giant magnetic resistance) Sensor. Diese Sensoren umfassen ein ferromagnetisches Widerstandselement, dessen elektrischer Widerstand von der Stärke des Magnetfelds abhängt. Der Magnetfeldsensor 2 kann des weiteren auch ein Fluxgate Sensor sein. Ein Fluxgate Sensor umfasst einen ferromagnetischen Kern. Das ferromagnetische Widerstandselement bzw. der ferromagnetische Kern ist auf der aktiven Oberfläche des Halbleiterchips 5 angeordnet und beeinflusst den Verlauf der magnetischen Feldlinien in ähnlicher Weise wie die Magnetfeldkonzentratoren 8 und 9 beim vorhergehenden Beispiel.

Im Beispiel ist das Gehäuse 1 in der als MID (molded interconnect device) bekannten Technologie gefertigt. Bei dieser Technologie werden im Spritzgussverfahren nacheinander ein metallisierbarer und ein nicht-metallisierbarer Kunststoff abgespritzt, wobei ein dreidimensionales Gehäuseunterteil entsteht. Anschliessend wird das Gehäuseunterteil für die Bildung von Leiterbahnen 11 metallisiert und bei Bedarf galvanisch verstärkt. Nach der Montage und elektrischen Verdrahtung des Magnetfeldsensors 2 mit den Leiterbahnen 11 im Gehäuseunterteil und der Montage der elektronischen Bauteile 6 wird das Gehäuseunterteil beispielsweise durch Vergiessen mit einem Kunststoff zum vollständigen Gehäuse 1 komplettiert. Die Leiterbahnen 11 enden auf einer Schmalseite des Gehäuses 1 als SMD Kontakte, so dass das Gehäuse 1 in der SMD (surface mount device) Technologie auf der Leiterplatte 4 befestigt werden kann. Vorteilhafterweise ist wenigstens die Fläche des Gehäuses 1, auf der der Halbleiterchip 5 aufliegt, metallisiert, um eine elektrische Abschirmungswirkung zu erzielen. Die MID Technologie bietet eine zweite Metallisierungsebene, die vorteilhafterweise für die Erzielung einer optimalen elektrischen Abschirmung benützt und entsprechend ausgestaltet wird.

Alternativ ist das Gehäuse 1 in einer herkömmlichen IC Technologie gefertigt, bei der der Halbleiterchip 5 auf einem sogenannten Leadframe montiert, verdrahtet und mit Kunststoff verkapselt wird, wobei der elektrische Kontakt mit der Leiterplatte 4 über elektrische Anschlussbeine erfolgt, die aus einer Schmalseite des Gehäuses 1 herausragen. Die Leiterplatte 4 kann z. B. Durchkontaktierungen für die Anschlussbeine des Gehäuses 1 aufweisen.

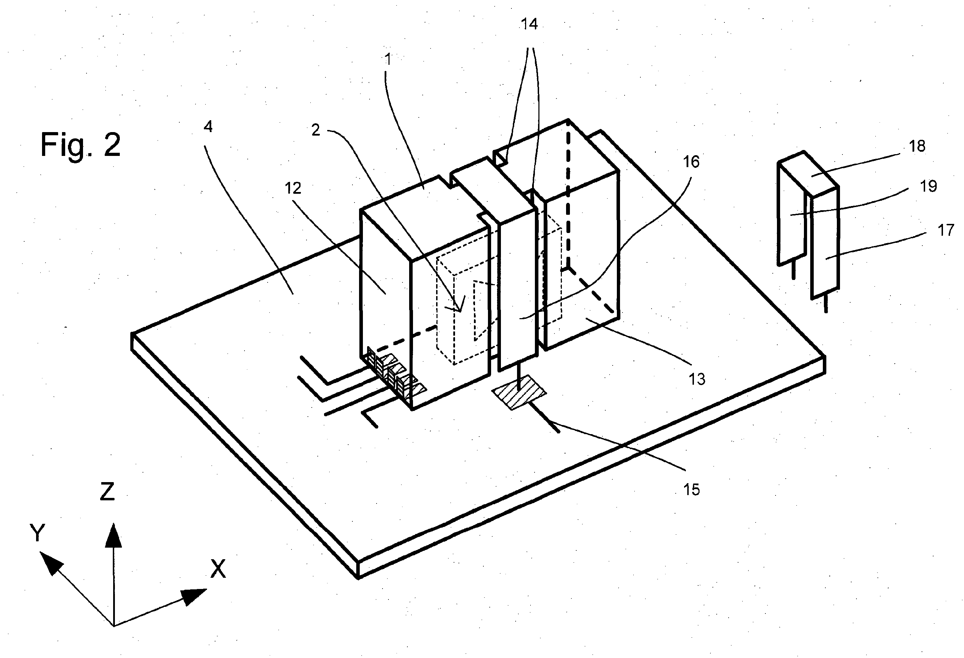

Die Fig. 2 zeigt ein Ausführungsbeispiel, bei dem der zu messende Strom über eine in der Leiterplatte 4 gebildete Leiterbahn 15 einem Ende eines Strombügels 16 aus Metall zugeführt und vom anderen Ende des Strombügels 16 wieder weggeführt wird. Der Strombügel 16 ist neben der Leiterplatte 4 nochmals dargestellt, er ist U-förmig, d.h. der Strombügel 16 besteht aus drei orthogonal zueinander verlaufenden Abschnitten 17, 18 und 19, wobei die Enden des Strombügels 16 so ausgebildet sind, dass sie auf der Leiterplatte 4 in Kontakt mit der Leiterbahn 15 befestigt werden können. Die beiden einander gegenüberliegenden, in x-Richtung verlaufenden breiten Aussenwände 12 und 13 des Gehäuses 1 sind mit einer Rille 14 versehen, die den ersten Abschnitt 17 und den dritten Abschnitt 19 des Strombügels 16 aufnimmt. Die Tiefe T der Rille 14 ist grösser als die Dicke D des Strombügels 16, so dass der Strombügel 16 elektrisch nicht in Kontakt kommt mit einem am Schluss montierten Schirm, der zur Abschirmung äusserer Magnetfelder dient.

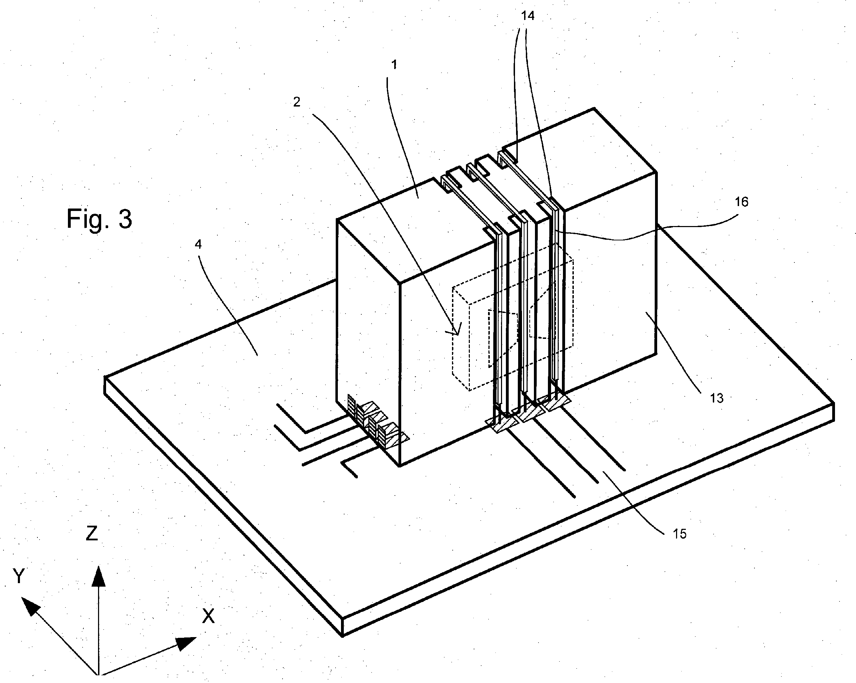

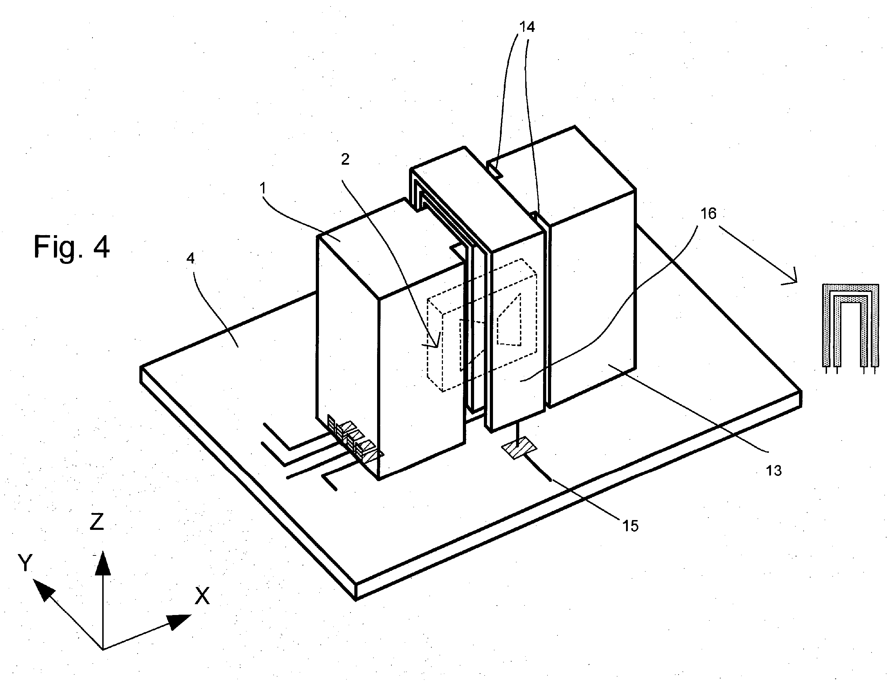

Das Gehäuse 1 kann auch, wie in der Fig. 3 gezeigt ist, mit zwei oder drei oder noch mehr Rillen 14 versehen sein, wobei jede Rille 14 einen Strombügel 16 aufnimmt. Die Strombügel 16 sind elektrisch in Reihe geschaltet, falls das von dem zu messenden Strom erzeugte Magnetfeld am Ort des Magnetfeldsensors 2 erhöht werden soll. Alternativ sind die Strombügel 16 elektrisch parallel geschaltet, falls die elektrische Belastung und die durch die elektrische Belastung verursachte thermische Belastung des Strombügels 16 verkleinert werden soll. Falls die Strombügel 16 nebeneinander nicht Platz finden, weil ihr Querschnitt eine vorbestimmte Mindestgrösse erreichen muss, die für eine bestimmte maximale Stromstärke ausgelegt ist, können die Strombügel 16 auch übereinander angeordnet sein. Dieses Ausführungsbeispiel ist in der Fig. 4 gezeigt. Die Strombügel 16 sind bevorzugt mit elektrisch nicht leitendem und somit isolierendem Klebstoff miteinander zu einem einzigen Bauteil verklebt.

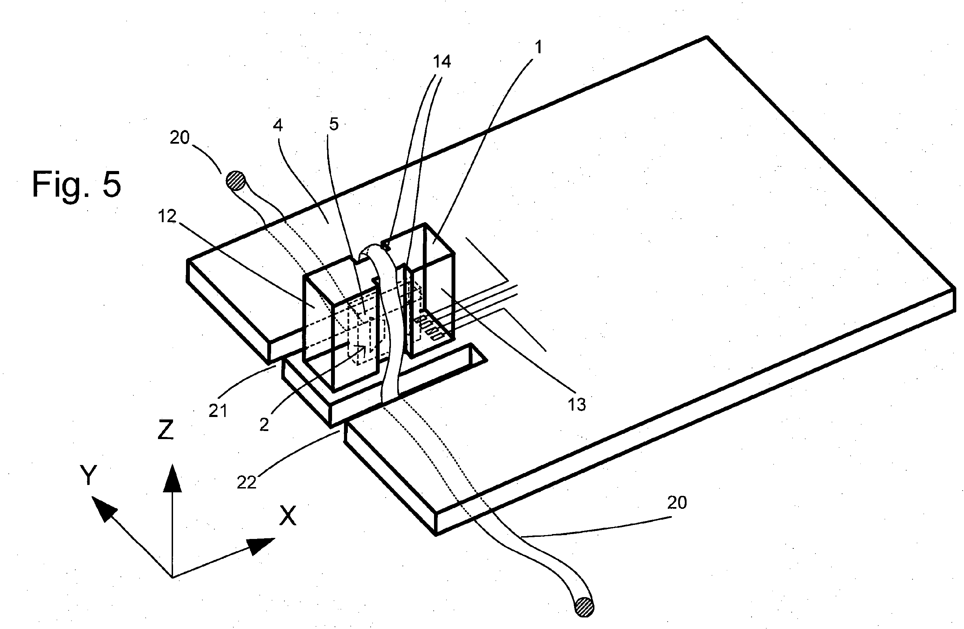

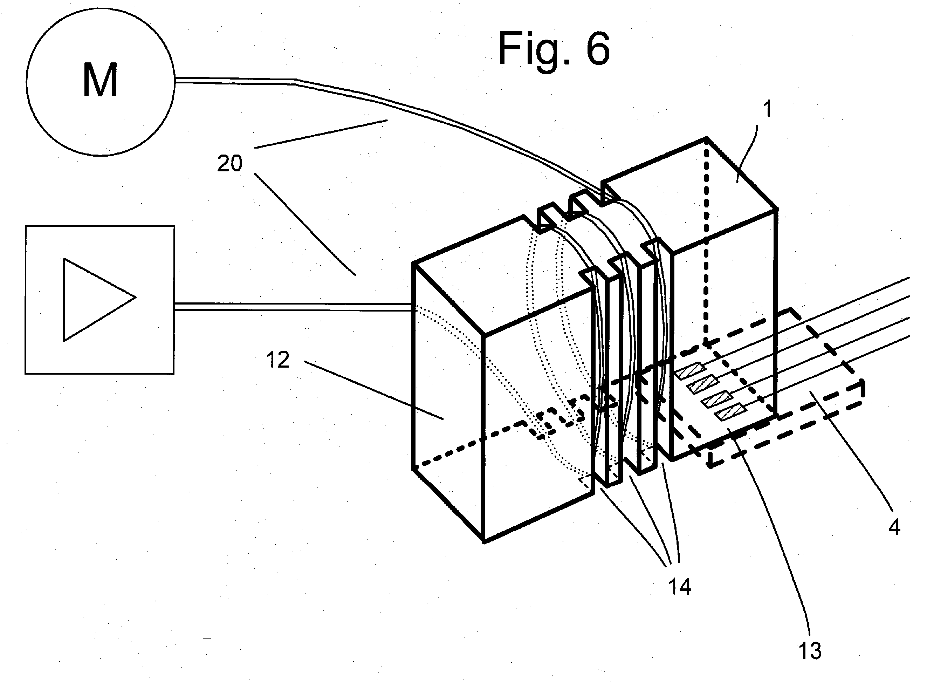

Die Fig. 5 zeigt ein Ausführungsbeispiel, bei dem der zu messende Strom über ein Kabel 20 zugeführt wird. Das Gehäuse 1 mit dem Magnetfeldsensor 2 befindet sich am Rand der Leiterplatte 4 und die Leiterplatte 4 ist mit zwei vom Rand ausgehenden Schlitzen 21 und 22 versehen, die parallel zu den Aussenwänden 12 und 13 verlaufen. Das Kabel 20 übernimmt die Funktionen der Leiterbahn 15 und des/der Strombügel 16 gemäss den vorherigen Ausführungsbeispielen. Das Kabel 20 wird in den Schlitz 21 und den Schlitz 22 und die Rille 14 hineingelegt, so dass es das Gehäuse 1 in gleicher Art wie ein Strombügel U-förmig umschliesst. Die Fig. 6 zeigt ein Ausführungsbeispiel, bei dem das Kabel 20 mehrmals um das Gehäuse 1 herum gewickelt ist. Die Leiterplatte 4 dient hier nur als Kontaktierungsglied zwischen dem Gehäuse 1 und einem Anschlusskabel, das die elektrischen Leitungen zum Magnetfeldsensor 2 beinhaltet. Die Leiterplatte 4 kann als Stecker ausgebildet sein, um eine lösbare Verbindung mit dem Anschlusskabel herstellen zu können. Diese Lösung erlaubt es, die Vorrichtung zur Strommessung an einem beliebigen Ort einzusetzen. Im Beispiel misst sie den Strom, der durch einen Motor M fliesst. Das Kabel 20 verbindet die Ausgangsstufe einer Steuereinheit mit dem Motor M. Das Kabel 20 kann um das Gehäuse 1 gewickelt werden, ohne dass es von der Steuereinheit oder vom Motor M gelöst werden muss.

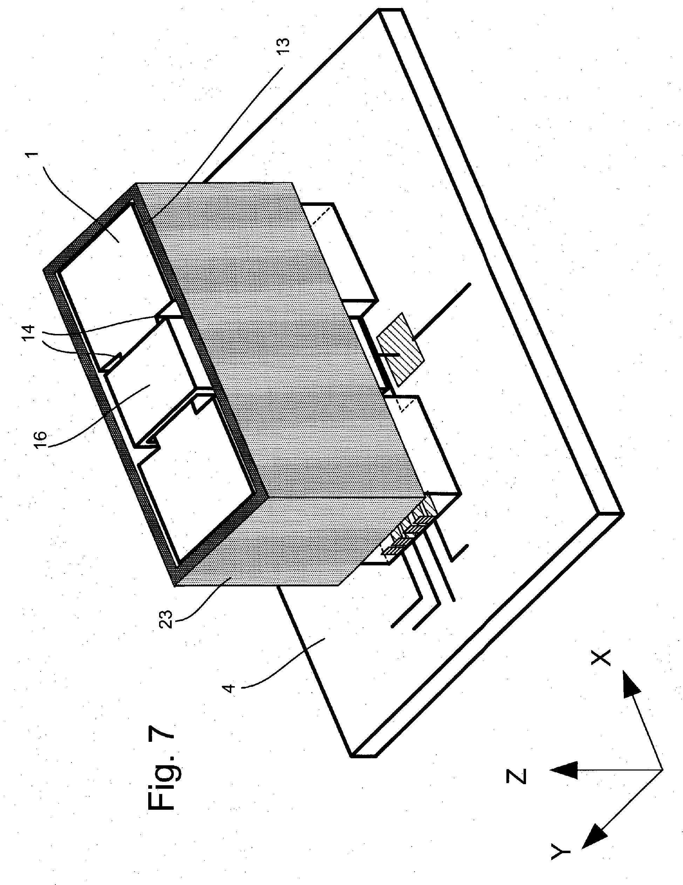

Die Fig. 7 zeigt die fertig montierte Vorrichtung zur Strommessung, die aus der Leiterplatte 4, dem Gehäuse 1 mit dem integrierten Magnetfeldsensor 2 und der Rille 14, mindestens einem Strombügel 16 bzw. dem Kabel 20 und einem Schirm 23 für die Abschirmung eines äusseren Magnetfelds besteht. Der Schirm 23 liegt an den Aussenwänden 12 und 13 auf beiden Seiten der Rille 14 an. Zwischen dem Strombügel 16 und dem Schirm 23 befindet sich ein kleiner Luftspalt. Die Tiefe der Rille 14 ist wie bereits weiter oben erläutert so bemessen, dass die Kontur des Gehäuses 1 als Abstandshalter für den Schirm 23 wirkt, derart, dass der Schirm 23 nicht in Kontakt kommt mit dem Strombügel 16. Der Schirm 23 und der Strombügel 16 sind also elektrisch voneinander getrennt, ohne dass weitere Massnahmen wie zum Beispiel das Anbringen einer Isolationsschicht auf den Schirm 23 oder den Strombügel 16 erforderlich sind. Bei diesem Beispiel ist der Schirm 23 am Gehäuse 1 angeklebt und so bemessen, dass ein Luftspalt zwischen dem unteren Rand des Schirms 23 und der Leiterplatte 4 verbleibt, der mindestens so gross ist, dass der Schirm 23 nicht in Kontakt kommt mit den elektrischen Anschlüssen des Gehäuses 1 und/oder den Leiterbahnen auf der Leiterplatte 4.

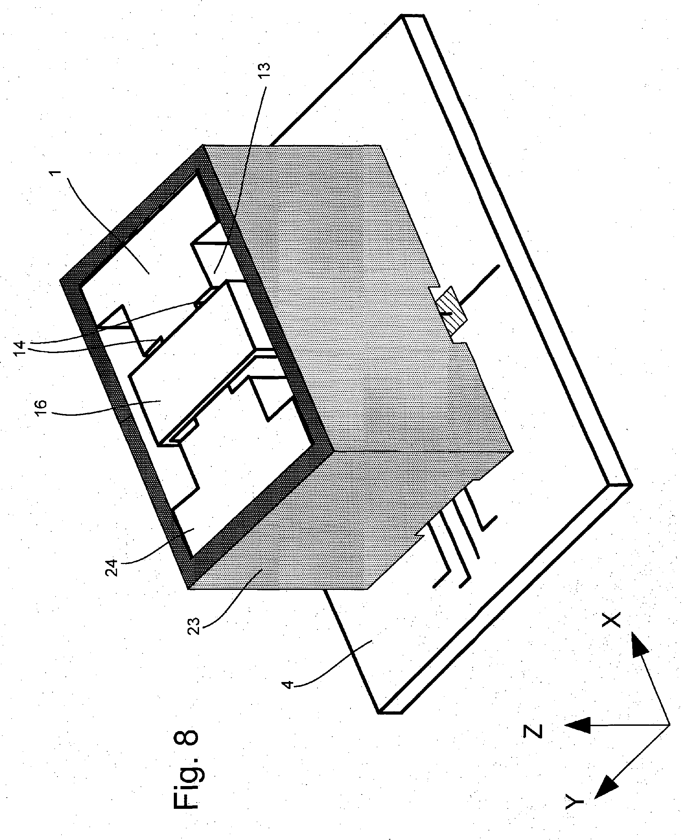

Die Fig. 8 zeigt ein weiteres Ausführungsbeispiel der fertig montierten Vorrichtung zur Strommessung, bei dem die Enden der Aussenwände 12 und 13 mit einem als Distanzgeber wirkenden Vorsprung 24 ausgebildet sind. Der Schirm 23 liegt an den Vorsprüngen 24 an und somit auch hier - beidseits der Rille 14 - an den Aussenwänden 12 und 13 an. Weil hier die Vorsprünge 24 die Funktion als Abstandshalter für den Schirm 23 übernehmen, ist es nicht mehr erforderlich, dass die Tiefe der Rille 14 grösser als die Dicke des Strombügels 16 ist. Bei diesem Beispiel weist der Schirm 23 Ausnehmungen auf im Bereich der elektrischen Anschlüsse des Gehäuses 1 und der Leiterbahnen auf der Leiterplatte 4. Bei der Montage wird der Schirm 23 über das Gehäuse 1 gestülpt, bis der Schirm 23 die Leiterplatte 4 berührt.

## Patentansprüche

1. Vorrichtung zur Strommessung, umfassend
eine Leiterplatte (4),
einen Stromleiter, durch den der zu messende Strom fliesst,
ein Gehäuse (1) mit einem im Gehäuse (1) angeordneten Magnetfeldsensor (2) für die Messung des Magnetfelds, das von dem durch den Stromleiter fliessenden Strom erzeugt wird, und
eine Abschirmung für die Abschirmung äusserer Magnetfelder, **dadurch gekennzeichnet, dass** das Gehäuse (1) eine flache, quaderförmige Form hat und derart auf der Leiterplatte (4) montiert ist, dass eine schmale Längswand auf der Leiterplatte (4) aufliegt, wobei der elektrische Kontakt mit der Leiterplatte (4) über an der schmalen Längswand des Gehäuses (1) angeordnete SMD Kontakte oder über elektrische Anschlussbeine erfolgt, die aus der schmalen Längswand des Gehäuses (1) herausragen,
dass zwei einander gegenüberliegende Aussenwände (12, 13) des Gehäuses (1) eine Rille (14) aufweisen, die eine Ebene E definiert,
dass der Stromleiter einen U-förmigen, auf der Leiterplatte (4) angelöteten Strombügel (16) mit drei im wesentlichen orthogonal zueinander verlaufenden Abschnitten (17, 18, 19) und eine in der Leiterplatte (4) angebrachte Leiterbahn (15) umfasst oder dass der Stromleiter ein Kabel (20) ist, wobei die Rille (14) den ersten und den dritten Abschnitt des Strombügels (16) bzw. das Kabel (20) aufnimmt,
dass der Magnetfeldsensor (2) einen Halbleiterchip umfasst, der sich in einer senkrecht zur Leiterplatte (4) verlaufenden Ebene erstreckt, und empfindlich ist auf ein Magnetfeld, das parallel zur aktiven Oberfläche des Halbleiterchips und senkrecht zur Ebene E verläuft,
dass die Abschirmung ein geschlossener Schirm (23) aus magnetischem Material ist, der auf beiden Seiten der Rille (14) an den besagten Aussenwänden (12, 13) anliegt, und dass im Fall der Ausführung mit dem Strombügel (16) die Tiefe der Rille (14) grösser als die Dicke des Strömbügels (16) oder das Gehäuse (1) mit Vorsprüngen (24) ausgebildet ist, so dass der Strombügel (16) elektrisch nicht in Kontakt kommt mit dem Schirm (23).

2. Vorrichtung nach Anspruch 1, **dadurch gekennzeichnet, dass** das Gehäuse (1) auf einer Aussenwand endende Leiterbahnen (11) aufweist.

3. Vorrichtung nach Anspruch 2, **dadurch gekennzeichnet, dass** der Magnetfeldsensor (2) ein im Halbleiterchip (5) integriertes Hallelement (10) und mindestens einen auf dem Halbleiterchip (5) angebrachten Magnetfeldkonzentrator (12, 13) umfasst.

4. Vorrichtung nach Anspruch 1 oder 2, **dadurch gekennzeichnet, dass** der Magnetfeldsensor (2) ein AMR oder GMR oder Fluxgate Sensor ist.

## Claims

1. Apparatus for measuring current, comprising
a printed circuit board (4),
a current conductor through which the current to be measured flows,
a housing (1) having a magnetic field sensor (2) arranged in the housing (1) for measuring the magnetic field which is generated by the current flowing through the current conductor, and a shielding for shielding external magnetic fields, **characterized in that** the housing (1) has a flat cuboidal shape and is mounted on the printed circuit board (4) in such a way that a narrow longitudinal wall rests on the printed circuit board (4), wherein the electrical contact with the printed circuit board (4) occurs via SMD contacts arranged on the narrow longitudinal wall of the housing (1) or via electrical leads which protrude from the narrow longitudinal wall of the housing (1),
that two mutually opposite outside walls (12, 13) of the housing (1) have a groove (14) which defines a plane E,
that the current conductor comprises a U-shaped conductor bow (16) which is soldered onto the printed circuit board (4) and comprises three sections (17, 18, 19) extending substantially orthogonally with respect to each other and a conductor path (16) attached to the printed circuit board (4), or that the current conductor is a cable (20), wherein the groove (14) accommodates the first and third section of the current bow (16) or the cable (20),
that the magnetic field sensor (2) comprises a semiconductor chip which extends in a plane extending perpendicularly to the printed circuit board (4) and which is sensitive to a magnetic field which extends parallel to the active surface of the semiconductor chip and perpendicularly to the plane E,
that the shielding is a closed shield (23) made of magnetic material which rests on both sides of the groove (14) on the said outside walls (12, 13), and that in the case of the arrangement with the current bow (16) the depth of the groove (14) is greater than the thickness of the current bow (16), or the housing (1) is formed with protrusions (24), so that the current bow (16) does not come into contact electrically with the shield (23).

2. Apparatus according to claim 1, **characterized in that** the housing (1) comprises conductor paths (11) ending on an outside wall.

3. Apparatus according to claim 2, **characterized in that** the magnetic field sensor (2) comprises a Hall element (10) integrated in the semiconductor chip (5) and at least one magnetic field concentrator (12, 13) attached to the semiconductor chip (5).

4. Apparatus according to claim 1 or 2, **characterized in that** the magnetic field sensor (2) is an AMR or GMR or fluxgate sensor.

## Revendications

1. Dispositif pour la mesure du courant, comprenant
une carte de circuits imprimés (4),
un conducteur électrique à travers lequel passe le courant à mesurer,
un boîtier (1) avec un capteur de champ magnétique (2) disposé dans le boîtier (1) pour la mesure du champ magnétique produit par le courant passant dans le conducteur électrique, et
un blindage pour blinder des champs magnétiques extérieurs,
**caractérisé en ce que** le boîtier (1) a une forme plate, parallélépipédique et est monté sur la carte de circuits imprimés (4) de telle manière qu'une paroi longue étroite repose sur la carte de circuits imprimés (4), le contact électrique avec la carte de circuits imprimés (4) étant établi par des contacts CMS ou des pattes de connexion électrique disposées sur la paroi longue étroite du boîtier (1), qui dépassent de la paroi longue étroite du boîtier (1),
**en ce que** deux parois extérieures (12, 13) du boîtier (1) opposées l'une à l'autre présentent une rainure (14) qui définit un plan E,
**en ce que** le conducteur électrique comprend un étrier conducteur (16) en forme de U brasé sur la carte de circuits imprimés (4) avec trois sections (17, 18, 19) sensiblement perpendiculaires les unes aux autres, et une piste conductrice (15) formée sur la carte de circuits imprimés (4) ou **en ce que** le conducteur électrique est un câble (20), la rainure (14) recevant la première et la troisième section de l'étrier conducteur (16) ou le câble (20),
**en ce que** le capteur de champ magnétique (2) comprend une puce de semi-conducteurs qui s'étend dans un plan perpendiculaire à la carte de circuits imprimés (4) et qui est sensible à un champ magnétique passant parallèlement à la surface active de la puce de semi-conducteurs et perpendiculairement au plan E,
**en ce que** le blindage est un blindage fermé (23) en matériau magnétique qui repose des deux côtés de la rainure (14) sur lesdites parois latérales (12, 13),
et **en ce que** dans la réalisation avec l'étrier conducteur (16), la profondeur de la rainure (14) est plus grande que l'épaisseur de l'étrier conducteur (16) ou le boîtier (1) est muni de saillies (24) de telle manière que l'étrier conducteur (16) ne vienne pas en contact électrique avec le blindage (23).

2. Dispositif selon la revendication 1, **caractérisé en ce que** le boîtier (1) présente des pistes conductrices (11) aboutissant à une paroi extérieure.

3. Dispositif selon la revendication 2, **caractérisé en ce que** le capteur de champ magnétique (2) comprend un élément à effet Hall (10) intégré dans la puce de semi-conducteurs (5) et au moins un concentrateur de champ magnétique (12, 13) disposé sur la puce de semi-conducteurs (5).

4. Dispositif selon la revendication 1 ou 2, **caractérisé en ce que** le capteur de champ magnétique (2) est un capteur AMR ou GMR ou Fluxgate.
